# EUROPÄISCHE PATENTSCHRIFT

(11) **EP 3 195 059 B1**
(45) Veröffentlichungstag und Bekanntmachung des Hinweises auf die Patenterteilung: **07.11.2018**
(21) Anmeldenummer: 14765969.2
(22) Anmeldetag: 15.09.2014
(51) Int. Cl.: G03F 7/20

(54) **VERBINDUNGSANORDNUNG ZUM KRAFTSCHLÜSSIGEN VERBINDEN VON KERAMIKBAUTEILEN**
CONNECTION ARRANGEMENT FOR THE NON-POSITIVE CONNECTION OF CERAMIC COMPONENTS
DISPOSITIF DE LIAISON POUR RELIER À FORCE DES COMPOSANTS CÉRAMIQUE

(43) Veröffentlichungstag der Anmeldung: 26.07.2017
(73) Patentinhaber: Carl Zeiss SMT GmbH, 73447 Oberkochen (DE)
(72) Erfinder: SIEGMANSKI, Karsten, 73431 Aalen (DE); DEUFEL, Peter, 89551 Königsbronn (DE); KULITZKI, Viktor, 08056 Zwickau (DE); XALTER, Stefan, 73447 Oberkochen (DE); GELLRICH, Bernhard, 73434 Aalen (DE)
(74) Vertreter: Horn Kleimann Waitzhofer Patentanwälte PartG mbB
(86) Internationale Anmeldenummer: PCT/EP2014/069642
(87) Internationale Veröffentlichungsnummer: WO 2016/041573

(56) Entgegenhaltungen:
- EP-A2- 1 531 364
- DE-A1-102013 209 012

## Beschreibung

Die vorliegende Erfindung betrifft eine Verbindungsanordnung zum kraftschlüssigen Verbinden von Keramikbauteilen für eine Lithographieanlage, einen Sensorrahmen für eine Lithographieanlage, eine Lithographieanlage und ein Verfahren zum kraftschlüssigen Verbinden von Keramikbauteilen für eine Lithographieanlage.

Lithographieanlagen werden beispielsweise bei der Herstellung von integrierten Schaltungen bzw. ICs verwendet, um ein Maskenmuster in einer Maske auf ein Substrat, wie z.B. einem Siliziumwafer, abzubilden. Dabei wird ein von einem optischen System erzeugtes Lichtbündel durch die Maske auf das Substrat gerichtet.

In Lithographieanlagen werden Keramikbauteile eingesetzt. Die Keramikbauteile werden miteinander verbunden. Eine Möglichkeit die Keramikbauteile miteinander zu verbinden, ist die Verwendung von durch entsprechende Öffnungen in den Keramikbauteilen geführte Metallschrauben. Formschlüssige Keramik-Metall-Verbindungsanordnungen haben den Nachteil, dass eine thermische Ausdehnung zu einer Beschädigung der Keramikbauteile führen kann. Zudem benötigen formschlüssige Verbindungsanordnungen eine hohe Präzision. Weiter können bei formschlüssigen Verbindungsanordnungen zu kleine Verbindungsbereiche bei großen Zugspannungen zu einer Beschädigung der Keramikbauteile führen.

Die EP 1 531 364 A2 zeigt eine Lithographieanlage mit einem Beleuchtungssystem, einer Stützstruktur zum Stützen eines Materialaufbringmittels, welches dazu dient, den Projektionsstrahl in seinem Querschnitt mit einem Muster zu versehen, einem Substrattisch zum Halten eines Substrats, einem Projektionssystem zum Projizieren des gemusterten Strahls auf einem Zielabschnitt des Substrats und einem isolierten Bezugsrahmen zum Bereitstellen einer Bezugsoberfläche, in Bezug auf welche das Substrat gemessen wird, wobei der Bezugsrahmen ein Material umfasst, das einen hohen thermischen Ausdehnungskoeffizienten aufweist.

Vor diesem Hintergrund besteht eine Aufgabe der vorliegenden Erfindung darin, eine verbesserte Verbindungsanordnung von Keramikbauteilen sowie ein Verfahren zum Verbinden von Keramikbauteilen bereitzustellen, wobei mindestens eines der vorgenannten Probleme gelöst wird. Insbesondere ist es eine Aufgabe der vorliegenden Erfindung eine Lithographieanlage bzw. einen Sensorrahmen für eine Lithographieanlage mit einer verbesserten Verbindungsanordnung von Keramikbauteilen bereitzustellen.

Diese Aufgabe wird durch eine Verbindungsanordnung zum kraftschlüssigen Verbinden von Keramikbauteilen für eine Lithographieanlage gelöst, welche ein erstes und ein zweites Keramikbauteil und eine Klemmvorrichtung aufweist. Die Klemmvorrichtung klemmt das erste und zweite Keramikbauteil kraftschlüssig unmittelbar gegeneinander. Die Klemmvorrichtung weist einen Schenkel und einen Bügel auf, wobei der Schenkel schwenkbar am Bügel befestigt ist.

Dadurch, dass die Klemmvorrichtung das erste und zweite Keramikbauteil kraftschlüssig, insbesondere reibschlüssig, und unmittelbar gegeneinander klemmt, kann auf eine formschlüssige Verbindungsanordnung verzichtet werden. Durch die kraftschlüssige Verbindungsanordnung wird das Verrutschen der Keramikbauteile gegeneinander verhindert. Vorteilhafterweise ist die kraftschlüssige Verbindungsanordnung leicht lösbar und leicht zugänglich. Zudem ist die kraftschlüssige Verbindung vakuumtauglich. Weiter können die Keramikbauteile nicht durch Zugspannungen oder thermische Ausdehnung beschädigt werden.

Der Ausdruck "unmittelbar" hat die Bedeutung, dass sich zwischen dem ersten Keramikbauteil und dem zweiten Keramikbauteil kein anderes Element befindet. Es wird durch die Klemmvorrichtung das erste Keramikbauteil direkt auf das zweite Keramikbauteil gedrückt.

Bei den Keramikbauteilen kann es sich insbesondere um Schalen bevorzugt eines Sensorrahmens der Lithographieanlage handeln. Die Schalen werden mittels der Klemmvorrichtung an ihren Stirnseiten, insbesondere an Stirnseiten von Flanschen der Schalen, aneinander befestigt. Bevorzugt erstreckt sich eine jeweilige Wandebene der Schalen in derselben Richtung wie die auf die Stirnseiten wirkende Klemmkraft (Vektor).

Gemäß einer Ausführungsform der Verbindungsanordnung umgreift die Klemmvorrichtung das erste und/oder zweite Keramikbauteil und/oder greift in das erste und/oder zweite Keramikbauteil ein. Damit die Klemmvorrichtung das erste Keramikbauteil gegen das zweite Keramikbauteil kraftschlüssig klemmen kann, muss sie auf beide Keramikbauteile eine Kraft ausüben. Um eine Kraft auf ein Keramikbauteil ausüben zu können, kann die Klemmvorrichtung in das Keramikbauteil an einer Ausnehmung des Keramikbauteils eingreifen. Alternativ kann die Klemmvorrichtung das Keramikbauteil auch umgreifen, z.B. an der Stelle einer Ausbuchtung des Keramikbauteils.

Die Klemmvorrichtung weist einen Schenkel und einen Bügel auf, wobei der Schenkel schwenkbar am Bügel befestigt ist. Der Schenkel und der Bügel können in Ausnehmungen der Keramikbauteile eingreifen. Dadurch, dass der Schenkel schwenkbar am Bügel befestigt ist, kann eingestellt werden, mit welchen Kräften Schenkel und Bügel auf die Keramikbauteile drücken.

Gemäß einer weiteren Ausführungsform der Verbindungsanordnung liegt eine von dem Schenkel ausgeübte Kraft und eine von dem Bügel ausgeübte Kraft jeweils in einer Wandebene der Keramikbauteile. Dadurch können die ausgeübten Kräfte senkrecht zu den kraftschlüssig zu verbindenden Kontaktflächen erfolgen.

Gemäß einer weiteren Ausführungsform der Verbindungsanordnung umfasst das erste Keramikbauteil eine erste Ausnehmung und einen ersten Keramikflansch mit einer ersten Seite und einer zweiten Seite. Weiter umfasst das zweite Keramikbauteil eine zweite Ausnehmung und einen zweiten Keramikflansch mit einer ersten Seite und einer zweiten Seite. Die erste Seite des ersten Keramikflansches ist durch die Klemmvorrichtung auf die erste Seite des zweiten Keramikflansches gedrückt, so dass zwischen den beiden Keramikflanschen eine kraftschlüssige Verbindung besteht. Der Schenkel der Klemmvorrichtung in der ersten Ausnehmung des ersten Keramikbauteils übt auf die zweite Seite des ersten Keramikflansches die Kraft aus und der Bügel der Klemmvorrichtung in der zweiten Ausnehmung des zweiten Keramikbauteils übt auf die zweite Seite des zweiten Keramikflansches die Kraft aus.

Gemäß einer weiteren Ausführungsform der Verbindungsanordnung weisen die Keramikflansche einen T-förmigen Querschnitt mit einem Fuß und mit einem Steg auf. Vorteilhafterweise kann durch den T-förmigen Querschnitt eine vergrößerte erste Seite eines Keramikflansches, d.h. eine vergrößerte Krafteinleitungsfläche, realisiert werden.

Gemäß einer weiteren Ausführungsform der Verbindungsanordnung weisen die Keramikflansche auf ihren ersten Seiten erhabene Kontaktflächen auf. Vorteilhafterweise kann mit den erhabenen Kontaktflächen die tatsächliche Verbindungsfläche reduziert werden.

Gemäß einer weiteren Ausführungsform der Verbindungsanordnung stehen die von dem Schenkel und dem Bügel ausgeübten Kräfte jeweils senkrecht zu den ersten Seiten und/oder den erhabenen Kontaktflächen. Vorteilhafterweise können die Keramikflansche dadurch geeignet kraftschlüssig verbunden werden.

Gemäß einer weiteren Ausführungsform der Verbindungsanordnung ist die erste Seite des ersten Keramikflanschs parallel zur ersten Seite des zweiten Keramikflanschs und/oder ist die erhabene Kontaktfläche des ersten Keramikflanschs parallel zur erhabenen Kontaktfläche des zweiten Keramikflansches. Dadurch, dass die Flächen, die kraftschlüssig aufeinander gepresst werden, parallel zueinander sind, kann eine kraftschlüssige Verbindung gut realisiert werden.

Gemäß einer weiteren Ausführungsform der Verbindungsanordnung ist zwischen dem ersten Keramikflansch des ersten Keramikbauteils und dem Schenkel der Klemmvorrichtung ein erstes Ausgleichselement für einen Toleranzausgleich zwischen dem ersten Keramikflansch und dem Schenkel vorgesehen und/oder ist zwischen dem zweiten Keramikflansch des zweiten Keramikbauteils und dem Bügel der Klemmvorrichtung ein zweites Ausgleichselement für einen Toleranzausgleich zwischen dem zweiten Keramikflansch und dem Bügel vorgesehen.

Das Ausgleichselement kann dafür sorgen, dass ein Unterschied in der Ausformung der Kontaktfläche des Schenkels bzw. der Kontaktfläche des Bügels und einer zweiten Seite eines Keramikflansches ausgeglichen wird. Weiter kann mit dem Ausgleichselement eine Schrägstellung des Schenkels bzw. des Bügels in Bezug auf die kraftschlüssig zu verbindenden Flächen ausgeglichen werden.

Gemäß einer weiteren Ausführungsform der Verbindungsanordnung weist der Schenkel eine zu dem ersten Ausgleichselement korrespondierende Ausnehmung auf und/oder weist der Bügel eine zu dem zweiten Ausgleichselement korrespondierende Ausnehmung auf. Vorteilhafterweise ergibt sich dadurch eine optimale Kraftübertragung.

Gemäß einer weiteren Ausführungsform der Verbindungsanordnung ist das erste Ausgleichselement an der zweiten Seite des ersten Keramikflansches in der ersten Ausnehmung des ersten Keramikbauteils angebracht und/oder ist das zweite Ausgleichselement an der zweiten Seite des zweiten Keramikflansches in der zweiten Ausnehmung des zweiten Keramikbauteils angebracht. Dadurch ist das jeweilige Ausgleichselement genau an der Position angebracht, an der der Schenkel und der Bügel Kräfte auf die Keramikbauteile ausüben.

Gemäß einer weiteren Ausführungsform der Verbindungsanordnung weist das erste Ausgleichselement eine geschliffene Kontaktfläche auf und/oder weist die zweite Seite des ersten Keramikflansches eine geschliffene Kontaktfläche auf, und/oder weist das zweite Ausgleichselement eine geschliffene Kontaktfläche auf und/oder weist die zweite Seite des zweiten Keramikflansches eine geschliffene Kontaktfläche auf. Bei geschliffenen Kontaktflächen lässt sich ein Ausgleichselement gut auf einem Keramikflansch aufbringen. Zudem kann es bei geschliffenen Kontaktflächen nicht zu lokalen Druckpunkten auf der zweiten Seite des Keramikflansches kommen.

Gemäß einer weiteren Ausführungsform der Verbindungsanordnung ist das erste Ausgleichselement auf der zweiten Seite des ersten Keramikflansches aufgeklebt und/oder ist das zweite Ausgleichselement auf der zweiten Seite des zweiten Keramikflansches aufgeklebt. Alternativ können Ausgleichselemente auch auf andere Weise an Keramikflanschen befestigt werden.

Gemäß einer weiteren Ausführungsform der Verbindungsanordnung ist das erste Ausgleichselement als Kalotte ausgebildet und/oder ist das zweite Ausgleichselement als Kalotte ausgebildet. Die Form der Kalotte ermöglicht, bei korrespondierender Form der Kontaktfläche des Schenkels bzw. der Kontaktfläche des Bügels, dass die Neigung des Schenkels bzw. die Neigung des Bügels variieren können.

Gemäß einer weiteren Ausführungsform der Verbindungsanordnung weist die Klemmvorrichtung eine Achse zum schwenkbar Befestigen des Schenkels am Bügel und eine Bewegungsschraube zum Einstellen der ausgeübten Kraft auf. Vorteilhafterweise lässt sich die ausgeübte Kraft je nach Bedarf mit der Bewegungsschraube einstellen.

Gemäß einer weiteren Ausführungsform der Verbindungsanordnung weist der Bügel der Klemmvorrichtung eine elliptische Krümmung auf. Dadurch werden die von Schenkel und Bügel ausgeübten Kräfte geeignet verteilt.

Gemäß einer weiteren Ausführungsform der Verbindungsanordnung weisen die Keramikbauteile Siliziumcarbid (SiSiC) auf. Vorteilhafterweise weist dieses Material nur eine geringe thermische Ausdehnung auf.

Weiter wird ein Sensorrahmen für eine Lithographieanlage, der eine Verbindungsanordnung wie beschrieben aufweist, vorgeschlagen.

Weiter wird eine Lithographieanlage, mit einem Sensorrahmen wie beschrieben oder mit einer Verbindungsanordnung wie beschrieben, vorgeschlagen.

Weiter wird ein Verfahren zum kraftschlüssigen Verbinden von Keramikbauteilen für eine Lithographieanlage, mit den folgenden Schritten vorgeschlagen. In einem ersten Schritt a) wird ein erstes Keramikbauteil unmittelbar neben einem zweiten Keramikbauteil positioniert. In einem zweiten Schritt b) wird das erste Keramikbauteil auf das zweite Keramikbauteil mittels einer Klemmvorrichtung gedrückt, wobei das erste und zweite Keramikbauteil kraftschlüssig gegeneinander geklemmt werden und wobei mittels Schwenkens eines Schenkels der Klemmvorrichtung Kräfte eingestellt werden, mit welchen der Schenkel und ein Bügel der Klemmvorrichtung auf das erste und zweite Keramikbauteil drücken.

Die für die vorgeschlagene Vorrichtung beschriebenen Ausführungsformen und Merkmale gelten für das vorgeschlagene Verfahren entsprechend.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt eine schematische Ansicht einer EUV-Lithographieanlage;
Fig. 2A zeigt eine perspektivische Ansicht eines Teils eines Sensorrahmens eines Projektionssystems aus Fig. 1;
Fig. 2B zeigt eine perspektivische Ansicht von Einzelkomponenten des Sensorrahmens;
Fig. 3 zeigt eine vergrößerte Ansicht aus Fig. 2A;
Fig. 4 zeigt eine perspektivische Ansicht einer Klemmvorrichtung;
Fig. 5 zeigt einen Schnitt durch die Klemmvorrichtung aus Fig. 4;
Fig. 6 zeigt einen Schnitt durch eine Verbindungsanordnung aus Fig. 3;
Fig. 7 zeigt eine perspektivische Ansicht eines Keramikflansches; und
Fig. 8 zeigt eine weitere perspektivische Ansicht des Keramikflansches aus Fig. 7.

Falls nichts anderes angegeben ist, bezeichnen gleiche Bezugszeichen in den Figuren gleiche oder funktionsgleiche Elemente. Ferner sollte beachtet werden, dass die Darstellungen in den Figuren nicht notwendigerweise maßstabsgerecht sind.

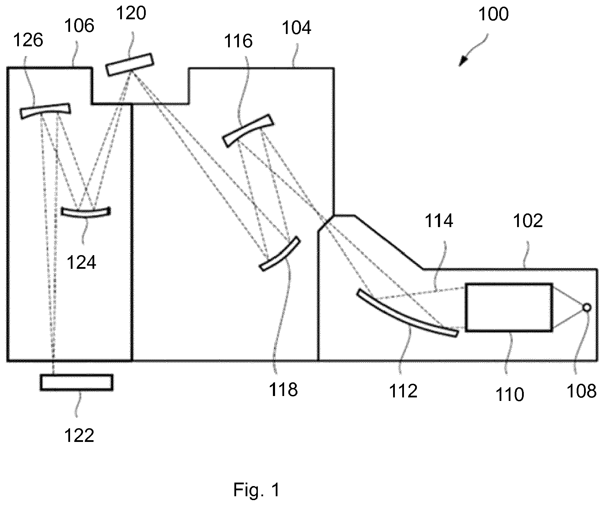

Fig. 1 zeigt eine schematische Ansicht einer EUV-Lithographieanlage 100, welche ein Strahlformungssystem 102, ein Beleuchtungssystem 104 und ein Projektionssystem 106 umfasst. Das Strahlformungssystem 102, das Beleuchtungssystem 104 und das Projektionssystem 106 sind jeweils in einem Vakuum-Gehäuse vorgesehen, welches mit Hilfe einer nicht näher dargestellten Evakuierungsvorrichtung evakuiert wird. Die Vakuum-Gehäuse sind von einem nicht näher dargestellten Maschinenraum umgeben, in welchem die Antriebsvorrichtungen zum mechanischen Verfahren bzw. Einstellen der optischen Elemente vorgesehen sind. Ferner können auch elektrische Steuerungen und dergleichen in diesem Maschinenraum vorgesehen sein.

Das Strahlformungssystem 102 weist eine EUV-Lichtquelle 108, einen Kollimator 110 und einen Monochromator 112 auf. Als EUV-Lichtquelle 108 kann beispielsweise eine Plasmaquelle oder ein Synchrotron vorgesehen sein, welche Strahlung im EUV-Bereich (extrem ultravioletten Bereich), also z.B. im Wellenlängenbereich von 5 nm bis 20 nm aussenden. Die von der EUV-Lichtquelle 108 austretende Strahlung wird zunächst durch den Kollimator 110 gebündelt, wonach durch den Monochromator 112 die gewünschte Betriebswellenlänge herausgefiltert wird. Somit passt das Strahlformungssystem 102 die Wellenlänge und die räumliche Verteilung des von der EUV-Lichtquelle 108 abgestrahlten Lichts an. Die von der EUV-Lichtquelle 108 erzeugte EUV-Strahlung 114 weist eine relativ niedrige Transmittivität durch Luft auf, weshalb die Strahlführungsräume im Strahlformungssystem 102, im Beleuchtungssystem 104 und im Projektionssystem bzw. Projektionsobjektiv 106 evakuiert sind.

Das Beleuchtungssystem 104 weist im dargestellten Beispiel einen ersten Spiegel 116 und einen zweiten Spiegel 118 auf. Diese Spiegel 116, 118 können beispielsweise als Facettenspiegel zur Pupillenformung ausgebildet sein und leiten die EUV-Strahlung 114 auf eine Photomaske 120.

Die Photomaske 120 ist ebenfalls als reflektives optisches Element ausgebildet und kann außerhalb der Systeme 102, 104, 106 angeordnet sein. Die Photomaske 120 weist eine Struktur auf, welche mittels des Projektionssystems 106 verkleinert auf einen Wafer 122 oder dergleichen abgebildet wird. Hierzu weist das Projektionssystem im Strahlführungsraum 106 beispielsweise einen dritten Spiegel 124 und einen vierten Spiegel 126 auf. Es sollte beachtet werden, dass die Anzahl der Spiegel der EUV-Lithographieanlage 100 nicht auf die dargestellte Anzahl beschränkt ist, und es können auch mehr oder weniger Spiegel vorgesehen sein. Des Weiteren sind die Spiegel i.d.R. an ihrer Vorderseite zur Strahlformung gekrümmt.

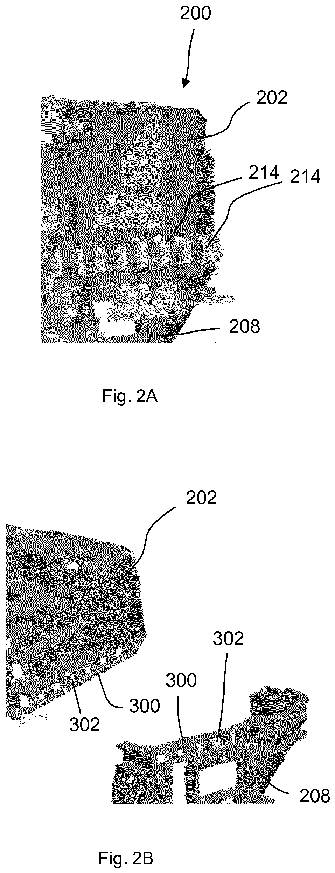

Das Projektionssystem 106 kann einen in Fig. 2A ausschnittsweise gezeigten Sensorrahmen (Engl.: Sensor Frame) 200 und einen nicht gezeigten Kraftrahmen (Engl.: Force Frame) aufweisen. Der Kraftrahmen kann diverse Subkomponenten wie z.B. Aktuatoren und aktive Spiegel tragen. Der Sensorrahmen 200 kann als feste Referenz die Sensoren und den einzigen passiven Spiegel tragen. Weiter kann der Sensorrahmen 200 um den vollständig aufgebauten Kraftrahmen montiert werden.

Eine Funktion des Sensorrahmens 200 ist die Bereitstellung einer hochsteifen Tragstruktur als globale Referenz. Zusätzlich muss die Zugänglichkeit zur inneren Struktur gewährleistet sein. Die thermische Verformung des Sensorrahmens 200 muss auf ein Minimum reduziert werden. Um dies im pm-Bereich zu gewährleisten, wird bevorzugt auf Keramikmaterial zurückgegriffen.

Ein Sensorrahmen besteht allgemein mitunter aus fünf Keramikbauteilen, den sogenannten Schalen (Engl.: Shells). In Fig. 2A zu sehen sind eine obere Schale (Engl.: Top Shell) 202 und eine erste zentrale Schale (Engl.: First Central Shell) 208. Eine untere Schale (Engl.: Bottom Shell) eine zweite zentrale Schale (Engl.: Second Central Shell) und eine vordere Schale (Front Shell) des Sensorrahmens 200 werden dagegen der besseren Übersicht halber nicht gezeigt. Die erste zentrale Schale 208, die zweite zentrale Schale und die vordere Schale bilden eine Mittelbaugruppe.

Wie in Fig. 2A zu sehen, werden die obere Schale 202 und die erste zentrale Schale 208 mittels Klemmvorrichtungen 214 zusammengehalten. Ebenfalls werden bspw. die erste zentrale Schale 208 und die untere Schale mittels Klemmvorrichtungen 214 zusammengehalten (nicht gezeigt).

Bei den Keramikbauteilen 202, 208 handelt es sich um hochsteife monolithische Keramikbauteile. Insbesondere können die Keramikbauteile 202, 208 Siliziumcarbid (SiSiC) aufweisen.

Die vorstehend erwähnte Mittelbaugruppe ist für die Gesamtsteifigkeit des Sensorrahmens 200 besonders relevant. Über in Fig. 2B gezeigte Keramikflansche 300 kann die erste zentrale Schale 208 mit der oberen Schale 202 verbunden werden. Genauer können die Keramikflansche 300 der Keramikbauteile 202, 208 kraftschlüssig mittels der Klemmvorrichtungen 214 gegeneinander geklemmt werden. Dabei können die Klemmvorrichtungen 214 in Ausnehmungen 302 in Form rechteckiger Fenster in den Keramikbauteilen 202, 208 eingreifen.

Fig. 2B zeigt die Keramikbauteile 202, 208 in Explosionsansicht. In dieser Darstellung sind die Keramikflansche 300 und die Ausnehmungen 302 zu erkennen.

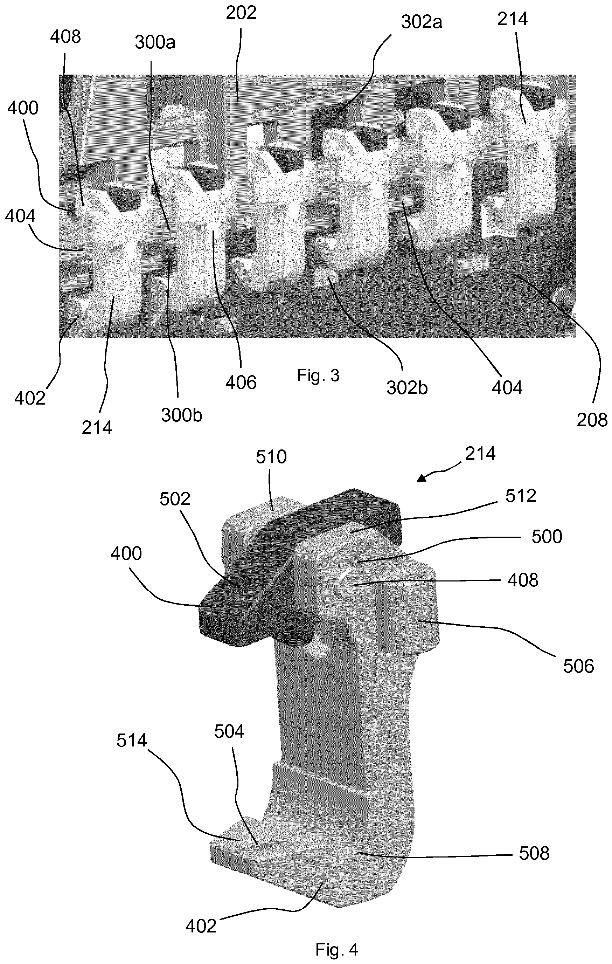

Fig. 3 zeigt eine perspektivische Ansicht von zwei verbundenen Keramikbauteilen 202, 208. Gezeigt werden - beispielhaft sechs - Klemmvorrichtungen 214, die jeweils in eine erste Ausnehmung 302a eines Keramikbauteils 202 und in eine zweite Ausnehmung 302b eines Keramikbauteils 208 eingreifen. Alternativ zu den in Fig. 3 gezeigten Ausnehmungen 302 können die Keramikbauteile 202, 208 auch Ausbuchtungen, beispielsweise korrespondierende vorstehende Ränder, aufweisen. Die Klemmvorrichtungen 214 würden dann die Ausbuchtungen oder Ränder umgreifen.

Es kann eine beliebige Anzahl von Klemmvorrichtungen 214 zum kraftschlüssigen Verbinden des ersten und zweiten Keramikflanschs 300a, 300b verwendet werden.

Die Klemmvorrichtungen 214 weisen jeweils - wie in Fig. 4 zu sehen - einen Schenkel 400 und einen Bügel 402 auf. Der Schenkel 400 ist bei der Klemmvorrichtung 214 schwenkbar am Bügel 402 befestigt. Der jeweilige Schenkel 400 kann mittels einer Achse 408 am Bügel drehbar befestigt werden. Über geschliffene Positioniermarkierungen 404 können die Keramikbauteile 202, 208 zueinander vermessen und ausgerichtet werden, und zwar so, wie sie kraftschlüssig miteinander verbunden werden sollen. Die Klemmvorrichtungen 214 umgreifen jeweils einen ersten Keramikflansch 300a eines ersten Keramikbauteils 202 und einen zweiten Keramikflansch 300b eines zweiten Keramikbauteils 208. Mittels einer Bewegungsschraube 406 der Klemmvorrichtung 214 kann der Schenkel 400 um die Achse 408 verschwenkt werden. Damit wird ein Druck auf den ersten Keramikflansch 300a und den zweiten Keramikflansch 300b ausgeübt.

Insbesondere ist bei der in Fig. 4 dargestellten Klemmvorrichtung 214 der Schenkel 400 zwischen gabelförmig verzweigten Enden 510, 512 des Bügels 402 gelagert. Die Welle oder Achse 408 verläuft durch das erste verzweigte Ende 510 des Bügels 402, den Schenkel 400 und das zweite verzweigte Ende 512 des Bügels 402, so dass sich der Schenkel 400 um die Achse 408 drehen kann. Der Sicherungsring 500, der sowohl am ersten als auch am zweiten verzweigten Ende 510, 512 vorgesehen ist, verhindert ein Herausfallen der Achse 408 aus dem Bügel.

Der Schenkel 400 kann Stahl und insbesondere Chromnickelstahl aufweisen. Der Bügel 402 kann ebenfalls Stahl aufweisen. An dem Element 506 mit Gewindebohrung kann eine Montagevorrichtung zur Montage der Klemmvorrichtung 214 befestigt werden. Der Bügel 402 weist eine Hakenform auf. Eine Krümmung 508 an dessen von dem Schenkel 400 abgewandten Ende kann eine elliptische Form haben. Die elliptische Krümmung 508 des Bügels 402 sorgt für eine optimale Verteilung der Kräfte, die Schenkel 400 und Bügel 402 ausüben, und verhindert ein nicht-gewolltes Aufspreizen des Bügels 402 beim Anziehen der Bewegungsschraube 406.

Die Klemmvorrichtung 214 ist für den Einsatz im Vakuum vorgesehen. Ein Belüftungsloch 504 des Bügels 402 sorgt dafür, dass sich zwischen einer Kontaktfläche 514 des Bügels 402 und dem Keramikflansch 300 keine eingeschlossene Luftblase bilden kann. Analog ist für den Schenkel 400 ebenfalls ein Belüftungsloch 502 vorgesehen.

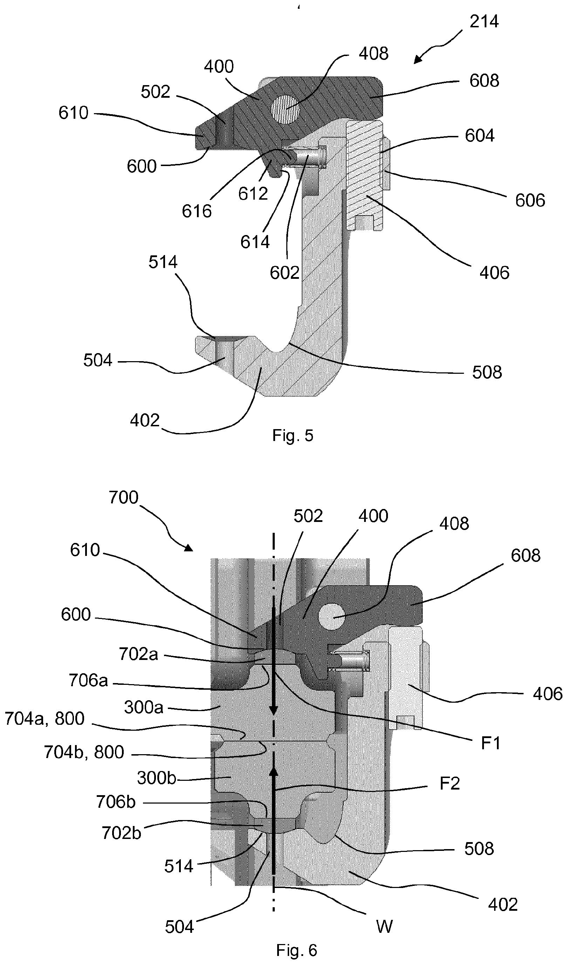

Fig. 5 zeigt eine Schnittansicht der in Fig. 4 gezeigten Klemmvorrichtung 214. Mit der Bewegungsschraube 406 kann die Kraft eingestellt werden, mit der Schenkel 400 und Bügel 402 auf die Keramikflansche 300 drücken. Die Bewegungsschraube 406 weist ein Gewinde 604 auf. Der Bügel 402 der Klemmvorrichtung 214 weist ein entsprechendes Gegengewinde 606 auf. Durch Drehen kann sich die Bewegungsschraube 406 mit ihrem Gewinde 604 im Gegengewinde 606 des Bügels 402 nach oben schrauben, so dass ein hinteres Ende 608 des Schenkels 400 nach oben gedrückt wird. Dies bewirkt, aufgrund der um die Achse 408 schwenkbaren Lagerung des Schenkels 400, ein Absenken eines vorderen Endes 610 des Schenkels 400. Eine Kontaktfläche 600 des Schenkels 400 und die Kontaktfläche 514 des Bügels 402 können dann auf zwei Keramikflansche drücken, die sich zwischen Schenkel 400 und Bügel 402 befinden. Die Kontaktfläche 600 des Schenkels 400 und die Kontaktfläche 514 des Bügels 402 können kegelförmig ausgebildet sein.

Der Schenkel 400 kann einen Vorsprung 612 aufweisen. An diesem Vorsprung befindet sich eine Fläche 614, von welcher ein Stift 616 abragt. Der Stift 616 drückt, bei der Bewegung der Bewegungsschraube 406 nach oben, eine Rückstellfeder 602 zusammen. Dies hat den Vorteil, dass, wenn die Bewegungsschraube 406 zurückgedreht wird, der Schenkel 400 durch die Rückstellkraft der Rückstellfeder 602 wieder in seine Ausgangsposition zurückkehrt.

Fig. 6 zeigt eine Verbindungsanordnung 700 zum kraftschlüssigen Verbinden von Keramikbauteilen 202, 208. Zu sehen ist die bereits in den Fig. 4 und 5 gezeigte Klemmvorrichtung 214. Die Klemmvorrichtung 214 klemmt zwei Keramikflansche 300 kraftschlüssig gegeneinander. Dazu drückt das vordere Ende 610 des Schenkels 400 gegen den ersten Keramikflansch 300a und der Bügel 402 drückt gegen den zweiten Keramikflansch 300b. Die gezeigten Keramikflansche 300 weisen beispielsweise einen T-förmigen Querschnitt auf.

Wie in Fig. 6 gezeigt, können Ausgleichselemente 702 zwischen dem Schenkel 400 bzw. dem Bügel 402 und dem jeweiligen Keramikflansch 300 verwendet werden. Wie zu sehen ist, übt das vordere Ende 610 des Schenkels 400 über die Kontaktfläche 600 eine Kraft F1 auf das erste Ausgleichselement 702a aus. Das erste Ausgleichselement 702a wird wiederum auf eine äußere Seite 706a des ersten Keramikflansches 300a gedrückt. Der Bügel 402 übt über seine Kontaktfläche 514 eine Kraft F2 auf das zweite Ausgleichselement 702b aus. Das zweite Ausgleichselement 702b wird wiederum auf eine äußere Seite 706b des zweiten Keramikflansches 300b gedrückt. Somit wird auch eine innere Seite 704a des ersten Keramikflansches 300a auf eine innere Seite 704b des zweiten Keramikflansches unmittelbar, d.h. Keramik gegen Keramik ohne Zwischenschaltung weiterer Komponenten, gedrückt. Zwischen dem ersten Keramikflansch 300a und dem zweiten Keramikflansch 300b besteht dann eine kraftschlüssige Verbindung durch Reibschluss in einer Ebene der Flächen 704a, 704b. In einer Richtung senkrecht zu der genannten Ebene, also in der Richtung, in welcher die Kräfte F1, F2 wirken, besteht ein Formschluss über die Klemmvorrichtung 214.

Die von dem Schenkel 400 ausgeübte Kraft F1 und die von dem Bügel 402 ausgeübte Kraft F2 verlaufen entlang eine Wandebene W in entgegengesetzte Richtungen. Dies hat den Vorteil, dass die über die entsprechenden Wände der Keramikbauteile 202, 208 ein- und ausgeleiteten Kräfte in diesen gut absorbiert werden können, diese insbesondere nicht oder nur geringfügig auf Biegung belasten.

Das erste Ausgleichselement 702a sorgt für einen Toleranzausgleich zwischen dem ersten Keramikflansch 300a und dem Schenkel 400. Das zweite Ausgleichselement 702b sorgt für einen Toleranzausgleich zwischen dem zweiten Keramikflansch 300b und dem Bügel 402. Die Ausgleichselemente 702 können Stahl aufweisen.

Weiter kann mit dem Ausgleichselement 702 eine Schrägstellung des Schenkels 400 bzw. des Bügels 402 in Bezug auf die kraftschlüssig zu verbindenden Flächen 704a, 704b ausgeglichen werden. Bevorzugt haben dabei der Schenkel 400 bzw. Bügel 402 eine zu dem entsprechenden Ausgleichselement 702a, 702b korrespondierende Ausnehmung, welche die Kontaktflächen 514, 600 aufweisen. Weiter kann das jeweilige Ausgleichselement 702a, 702b als Kalotte ausgebildet sein.

Damit das Ausgleichselement 702a, 702b möglichst keine Druck- und Spannungsspitzen im Keramikflansch 300 erzeugen kann, ist eine geschliffene Kontaktfläche des Ausgleichselements 702a, 702b und eine geschliffene Kontaktfläche an den Seiten 706a, 706b der Keramikflansche 300 von Vorteil.

Die Ausgleichselemente 702a, 702b können auf die Seiten 706a, 706b der Keramikflansche 300 geklebt sein, insbesondere mittels eines Mehrkomponentenklebers. Die Ausgleichselemente 702a, 702b können allerdings auch auf andere Weise befestigt werden.

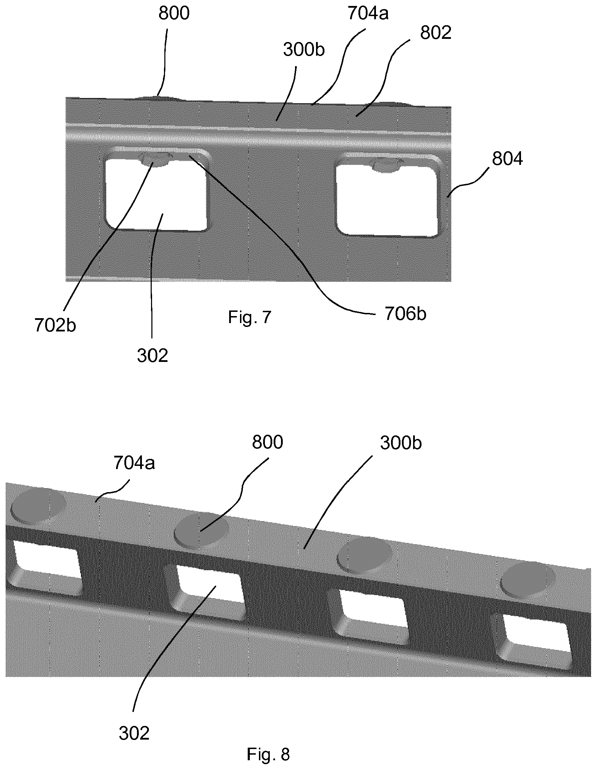

Fig. 7 zeigt eine perspektivische Ansicht eines Keramikbauteils 202, 208 umfassend den Keramikflansch 300b aus Fig. 6 von schräg unten, Fig. 8 zeigt die Ansicht von schräg oben. Der gezeigte Keramikflansch 300b ist T-förmig und weist einen Steg 804 und einen Fuß 802 auf. Weiter weist der Keramikflansch 300b an seiner inneren Seite 704 geschliffene, erhabene Kontaktflächen 800 auf. In den Ausnehmungen 302 sind die Ausgleichselemente 702b an der äußeren Seite des Keramikflansches 300 angebracht. In diesem Fall ergibt sich der direkte Kontakt zwischen den Keramikbauteilen 202, 208 nur über die Kontaktflächen 800, wie auch in Fig. 6 verdeutlicht.

Durch die Verwendung der T-förmigen Keramikflansche 300 kann eine große Krafteinleitungsfläche realisiert werden. Gleichzeitig kann die gesamte Verbindungsfläche der Keramikflansche 300 durch die Verwendung der erhabenen Kontaktflächen 800 reduziert werden.

Obwohl die vorliegende Erfindung anhand von Ausführungsbeispielen beschrieben wurde, ist sie darauf keineswegs beschränkt, sondern vielfältig modifizierbar.

Alternativ kann der Schenkel 400 der Klemmvorrichtung 214 ein Kugelgelenk aufweisen. Das erste Ausgleichselement 702a ist in diesem Fall mit dem Kugelgelenk verbunden. Der Bügel 402 der Klemmvorrichtung 214 kann ebenfalls ein Kugelgelenk aufweisen, welches mit dem zweiten Ausgleichselement 702b verbunden sein kann.

In einer alternativen Ausführungsform kann der Schenkel 400 gespreizt sein. Damit ergibt sich ein gespreizter Hebelarm.

In einer weiteren alternativen Ausführungsform kann die Klemmvorrichtung 214 eine Schraubzwinge aufweisen.

In einer weiteren alternativen Ausführungsform kann die Klemmvorrichtung 214 federnde Elemente zum Ausgleich einer etwaigen thermischen Nachgiebigkeit der Keramikbauteile 202, 208 aufweisen.

Bei der Lithographieanlage 100 muss es sich nicht um eine EUV-Lithographieanlage handeln; vielmehr könne auch Licht anderer Wellenlänge (beispielsweise 193 nm mittels ArF-Excimerlaser) verwendet werden. Ferner können anstelle der genannten Spiegel auch Linsen insbesondere in dem genannten Projektionssystem 106 verwendet werden.

Grundsätzlich können mittels der Klemmvorrichtungen 214 beliebige Bauteile, insbesondere beliebige Schalen, miteinander verbunden werden.

### BEZUGSZEICHENLISTE

- 100: EUV-Lithographieanlage
- 102: Strahlformungssystem
- 104: Beleuchtungssystem
- 106: Projektionssystem
- 108: EUV-Lichtquelle
- 110: Kollimator
- 112: Monochromator
- 114: EUV-Strahlung
- 116: erster Spiegel
- 118: zweiter Spiegel
- 120: Photomaske
- 122: Wafer
- 124: dritter Spiegel
- 126: vierter Spiegel
- 200: Sensorrahmen (Sensor Frame)
- 202: obere Schale (Top Shell)
- 208: erste zentrale Schale (First Central Shell)
- 214: Klemmvorrichtung
- 300: Keramikflansch
- 300a: erster Keramikflansch
- 300b: zweiter Keramikflansch
- 302: Ausnehmung
- 302a: erste Ausnehmung
- 302b: zweite Ausnehmung
- 400: Schenkel
- 402: Bügel
- 404: Positioniermarkierung
- 406: Bewegungsschraube
- 408: Achse
- 500: Sicherungsring
- 502: Belüftungsloch des Schenkels
- 504: Belüftungsloch des Bügels
- 506: Element mit Gewindebohrung
- 508: Krümmung
- 510: erstes verzweigtes Ende des Bügels
- 512: zweites verzweigtes Ende des Bügels
- 514: Kontaktfläche des Bügels
- 600: Kontaktfläche des Schenkels
- 602: Rückstellfeder
- 604: Gewinde der Schraube
- 606: Gewinde der Klemmvorrichtung
- 608: hinteres Ende des Schenkels
- 610: vorderes Ende des Schenkels
- 612: Vorsprung am Schenkel
- 614: Fläche am Vorsprung des Schenkels
- 616: Stift an der Fläche des Vorsprungs
- 700: Verbindungsanordnung
- 702: Ausgleichselement
- 702a: erstes Ausgleichselement
- 702b: zweites Ausgleichselement
- 704: erste Seite eines Keramikflansches
- 704a: erste Seite des ersten Keramikflansches
- 704b: erste Seite des zweiten Keramikflansches
- 706: zweite Seite eines Keramikflansches
- 706a: zweite Seite des ersten Keramikflansches
- 706b: zweite Seite des zweiten Keramikflansches
- 800: erhabene Kontaktfläche des Keramikflansches
- 802: Fuß
- 804: Steg
- F1: Kraft, die der Schenkel ausübt
- F2: Kraft, die der Bügel ausübt
- W: Wandebene

## Patentansprüche

1. Verbindungsanordnung (700) zum kraftschlüssigen Verbinden von Keramikbauteilen (202, 208) für eine Lithographieanlage (100), aufweisend:
ein erstes und ein zweites Keramikbauteil (202, 208), und
eine Klemmvorrichtung (214), welche das erste und zweite Keramikbauteil (202, 208) kraftschlüssig unmittelbar gegeneinander klemmt, wobei die Klemmvorrichtung (214) einen Schenkel (400) und einen Bügel (402) aufweist und der Schenkel (400) schwenkbar an dem Bügel (402) befestigt ist.

2. Verbindungsanordnung gemäß Anspruch 1, wobei die Klemmvorrichtung (214) das erste und/oder zweite Keramikbauteil (202, 208) umgreift und/oder in das erste und/oder zweite Keramikbauteil (202, 208, 210) eingreift.

3. Verbindungsanordnung gemäß Anspruch 1 oder 2, wobei eine von dem Schenkel (400) ausgeübte Kraft (F1) und eine von dem Bügel (402) ausgeübte Kraft (F2) jeweils in einer Wandebene (W) der Keramikbauteile (202, 208, 210) liegt.

4. Verbindungsanordnung gemäß Anspruch 3,
wobei das erste Keramikbauteil (202, 208) eine erste Ausnehmung (302a) und einen ersten Keramikflansch (300a) mit einer ersten Seite (704a) und einer zweiten Seite (706a) umfasst,
wobei das zweite Keramikbauteil (202, 208) eine zweite Ausnehmung (302b) und einen zweiten Keramikflansch (300b) mit einer ersten Seite (704b) und einer zweiten Seite (706b) umfasst,
wobei die erste Seite (704a) des ersten Keramikflansches (300a) durch die Klemmvorrichtung (214) auf die erste Seite (704b) des zweiten Keramikflansches (300b) gedrückt ist, so dass zwischen den beiden Keramikflanschen (300a, 300b) eine kraftschlüssige Verbindung besteht, und
wobei der Schenkel (400) der Klemmvorrichtung (214) in der ersten Ausnehmung (302a) des ersten Keramikbauteils (202, 208) auf die zweite Seite (706a) des ersten Keramikflansches (300a) die Kraft (F1) ausübt und der Bügel (402) der Klemmvorrichtung (214) in der zweiten Ausnehmung (302b) des zweiten Keramikbauteils (202, 208) auf die zweite Seite (706b) des zweiten Keramikflansches (300b) die Kraft (F2) ausübt.

5. Verbindungsanordnung gemäß Anspruch 4, wobei die Keramikflansche (300) einen T-förmigen Querschnitt mit einem Fuß (802) und mit einem Steg (804) aufweisen.

6. Verbindungsanordnung gemäß Anspruch 4 oder 5, wobei die Keramikflansche (300) auf ihren ersten Seiten (704) erhabene Kontaktflächen (800) aufweisen.

7. Verbindungsanordnung gemäß einem der Ansprüche 4 bis 6, wobei die von dem Schenkel (400) und dem Bügel (402) ausgeübten Kräfte (F1, F2) jeweils senkrecht zu den ersten Seiten (704) und/oder den erhabenen Kontaktflächen (800) stehen.

8. Verbindungsanordnung gemäß einem der Ansprüche 4 bis 7, wobei die erste Seite (704a) des ersten Keramikflanschs (300a) parallel zur ersten Seite (704b) des zweiten Keramikflanschs (300b) ist und/oder wobei die erhabene Kontaktfläche (800) des ersten Keramikflanschs (300a) parallel zur erhabenen Kontaktfläche (800) des zweiten Keramikflansches (300b) ist.

9. Verbindungsanordnung gemäß einem der Ansprüche 4 bis 8, wobei zwischen dem ersten Keramikflansch (300a) des ersten Keramikbauteils (202, 208) und dem Schenkel (400) der Klemmvorrichtung (214) ein erstes Ausgleichselement (702a) für einen Toleranzausgleich zwischen dem ersten Keramikflansch (300a) und dem Schenkel (400) vorgesehen ist und/oder wobei zwischen dem zweiten Keramikflansch (300b) des zweiten Keramikbauteils (202, 208) und dem Bügel (402) der Klemmvorrichtung (214) ein zweites Ausgleichselement (702b) für einen Toleranzausgleich zwischen dem zweiten Keramikflansch (300b) und dem Bügel (402) vorgesehen ist.

10. Verbindungsanordnung gemäß Anspruch 9, wobei der Schenkel (400) eine zu dem ersten Ausgleichselement (702a) korrespondierende Ausnehmung aufweist und/oder wobei der Bügel (402) eine zu dem zweiten Ausgleichselement (702b) korrespondierende Ausnehmung aufweist.

11. Verbindungsanordnung gemäß Anspruch 9 oder 10, wobei das erste Ausgleichselement (702a) auf der zweiten Seite (706a) des ersten Keramikflansches (300a) aufgeklebt ist und/oder wobei das zweite Ausgleichselement (702b) auf der zweiten Seite (706b) des zweiten Keramikflansches (300b) aufgeklebt ist.

12. Verbindungsanordnung gemäß einem der Ansprüche 1 bis 11, wobei die Klemmvorrichtung (214) eine Achse (408) zum schwenkbar Befestigen des Schenkels (400) am Bügel (402) und eine Bewegungsschraube (406) zum Einstellen der ausgeübten Kraft (F1, F2) aufweist.

13. Sensorrahmen (200) für eine Lithographieanlage (100), aufweisend eine Verbindungsanordnung (700) gemäß einem der Ansprüche 1 bis 12.

14. Lithographieanlage (100) mit einem Sensorrahmen (200) gemäß Anspruch 13 oder mit einer Verbindungsanordnung (700) gemäß einem der Ansprüche 1 bis 12.

15. Verfahren zum kraftschlüssigen Verbinden von Keramikbauteilen (202, 208) für eine Lithographieanlage, mit den Schritten:
a) Positionieren eines ersten Keramikbauteils (202, 208) unmittelbar neben einem zweiten Keramikbauteil (202, 208),
b) Drücken des ersten Keramikbauteils (202, 208) auf das zweite Keramikbauteil (202, 208) mittels einer Klemmvorrichtung (214), wobei das erste und zweite Keramikbauteil (202, 208) kraftschlüssig gegeneinander geklemmt werden und wobei mittels Schwenkens eines Schenkels (400) der Klemmvorrichtung (214) Kräfte eingestellt werden, mit welchen der Schenkel (400) und ein Bügel (402) der Klemmvorrichtung (214) auf das erste und zweite Keramikbauteil (202, 208) drücken.

## Claims

1. Connection arrangement (700) for a force-fit connection between ceramic components (202, 208) for a lithography apparatus (100), comprising:
a first and a second ceramic component (202, 208), and
a clamping device (214), which directly clamps the first and the second ceramic component (202, 208) against one another in a force-fit manner, wherein the clamping device (214) has a limb (400) and a clamp (402) and the limb (400) is fastened to the clamp (402) in a swivelable manner.

2. Connection arrangement according to Claim 1, wherein the clamping device (214) engages around the first and/or second ceramic component (202, 208) and/or engages into the first and/or second ceramic component (202, 208, 210).

3. Connection arrangement according to Claim 1 or 2, wherein a force (F1) exerted by the limb (400) and a force (F2) exerted by the clamp (402) each lie in a wall plane (W) of the ceramic components (202, 208, 210).

4. Connection arrangement according to Claim 3, wherein the first ceramic component (202, 208) comprises a first recess (302a) and a first ceramic flange (300a) with a first side (704a) and a second side (706a),
wherein the second ceramic component (202, 208) comprises a second recess (302b) and a second ceramic flange (300b) with a first side (704b) and a second side (706b),
wherein the first side (704a) of the first ceramic flange (300a) is pressed against the first side (704b) of the second ceramic flange (300b) by the clamping device (214) in such a way that there is a force-fit connection between both ceramic flanges (300a, 300b), and
wherein the limb (400) of the clamping device (214), in the first recess (302a) of the first ceramic component (202, 208), exerts the force (F1) on the second side (706a) of the first ceramic flange (300a) and the clamp (402) of the clamping device (214), in the second recess (302b) of the second ceramic component (202, 208), exerts the force (F2) on the second side (706b) of the second ceramic flange (300b).

5. Connection arrangement according to Claim 4, wherein the ceramic flanges (300) have a T-shaped cross section with a foot (802) and a web (804).

6. Connection arrangement according to Claim 4 or 5, wherein the ceramic flanges (300) have raised contact surfaces (800) on the first sides (704) thereof.

7. Connection arrangement according to one of Claims 4 to 6, wherein the forces (F1, F2) exerted by the limb (400) and the clamp (402) are respectively perpendicular to the first sides (704) and/or the raised contact surfaces (800).

8. Connection arrangement according to one of Claims 4 to 7, wherein the first side (704a) of the first ceramic flange (300a) is parallel to the first side (704b) of the second ceramic flange (300b) and/or wherein the raised contact surface (800) of the first ceramic flange (300a) is parallel to the raised contact surface (800) of the second ceramic flange (300b).

9. Connection arrangement according to one of Claims 4 to 8, wherein a first compensation element (702a) is provided between the first ceramic flange (300a) of the first ceramic component (202, 208) and the limb (400) of the clamping device (214) for compensating tolerances between the first ceramic flange (300a) and the limb (400) and/or wherein a second compensation element (702b) is provided between the second ceramic flange (300b) of the second ceramic component (202, 208) and the clamp (402) of the clamping device (214) for compensating tolerances between the second ceramic flange (300b) and the clamp (402).

10. Connection arrangement according to Claim 9, wherein the limb (400) has a recess corresponding to the first compensation element (702a) and/or wherein the clamp (402) has a recess corresponding to the second compensation element (702b).

11. Connection arrangement according to Claim 9 or 10, wherein the first compensation element (702a) is adhesively bonded to the second side (706a) of the first ceramic flange (300a) and/or wherein the second compensation element (702b) is adhesively bonded to the second side (706b) of the second ceramic flange (300b).

12. Connection arrangement according to one of Claims 1 to 11, wherein the clamping device (214) has a shaft (408) for fastening the limb (400) to the clamp (402) in a swivelable manner and a movement screw (406) for setting the exerted force (F1, F2).

13. Sensor frame (200) for a lithography apparatus (100), comprising a connection arrangement (700) according to one of Claims 1 to 12.

14. Lithography apparatus (100) comprising a sensor frame (200) according to Claim 13 or comprising a connection arrangement (700) according to one of Claims 1 to 12.

15. Method for a force-fit connection between ceramic components (202, 208) for a lithography apparatus, comprising the following steps:
a) positioning a first ceramic component (202, 208) directly next to a second ceramic component (202, 208),
b) pressing the first ceramic component (202, 208) onto the second ceramic component (202, 208) by means of a clamping device (214), wherein the first and second ceramic components (202, 208) are clamped against one another in a force-fit manner, and wherein, by means of swiveling a limb (400) of the clamping device (214), forces are set, with which the limb (400) and a clamp (402) of the clamping device (214) press on the first and second ceramic components (202, 208).

## Revendications

1. Agencement d'assemblage (700), destiné à l'assemblage par complémentarité de force de composants en céramique (202, 208) pour une installation lithographique (100), comportant
un premier et un deuxième composants en céramique (202, 208), et
un dispositif de serrage (214), qui serre directement l'un contre l'autre par complémentarité de force le premier et le deuxième composants en céramique (202, 208), le dispositif de serrage (214) comportant une branche (400) et un étrier (402) et la branche (400) étant fixée de manière pivotante sur l'étrier (402).

2. Agencement d'assemblage selon la revendication 1, le dispositif de serrage (214) entourant le premier et/ou le deuxième composants en céramique (202, 208) et/ou s'engageant dans le premier et/ou le deuxième composants en céramique (202, 208, 210).

3. Agencement d'assemblage selon la revendication 1 ou 2, une force (F1) exercée par la branche (400) et une force (F2) exercée par l'étrier (402) se situant respectivement dans un plan de paroi (W) des composants en céramique (202, 208, 210).

4. Agencement d'assemblage selon la revendication 3,
le premier composant en céramique (202, 208) comprenant un premier évidement (302a) et une première bride en céramique (300a) pourvue d'une première face (704a) et d'une deuxième face (706a),
le deuxième composant en céramique (202, 208) comprenant un deuxième évidement (302b) et une deuxième bride en céramique (300b) pourvue d'une première face (704b) et d'une deuxième face (706b),
la première face (704a) de la première bride en céramique (300a) étant pressée par le dispositif de serrage (214) sur la première face (704b) de la deuxième bride en céramique (300b), de sorte qu'entre les deux brides en céramique (300a, 300b) il reste un assemblage par complémentarité de force et
dans le premier évidement (302a) du premier composant en céramique (202, 208), la branche (400) du dispositif de serrage (214) exerçant la force (F1) sur la deuxième face de la première (706a) bride en céramique (300a) et dans le deuxième évidement (302b), l'étrier (402) du dispositif de serrage (214) du deuxième composant en céramique (202, 208) exerçant la force (F2) sur la deuxième face (706b) de la deuxième bride en céramique (300b).

5. Agencement d'assemblage selon la revendication 4, les brides en céramique (300) présentant une section transversale en forme de T, dotée d'un pied (802) et d'une barrette (804).

6. Agencement d'assemblage selon la revendication 4 ou 5, sur leurs première faces (704), les brides en céramique (300) comportant des surfaces de contact (800) proéminentes.

7. Agencement d'assemblage selon l'une quelconque des revendications 4 à 6, les forces (F1, F2) exercées par la branche (400) et par l'étrier (402) se tenant toujours à la perpendiculaire des premières faces (704) et/ou des surfaces de contact (800) proéminentes.

8. Agencement d'assemblage selon l'une quelconque des revendications 4 à 7, la première face (704a) de la première bride en céramique (300a) étant parallèle à la première face (704b) de la deuxième bride en céramique (300b) et/ou les surfaces de contact (800) proéminentes de la première bride en céramique (300a) étant parallèles aux surfaces de contact (800) proéminentes de la deuxième bride en céramique (300b).

9. Agencement d'assemblage selon l'une quelconque des revendications 4 à 8, entre la première bride en céramique (300a) du premier composant en céramique (202, 208) et la branche (400) du dispositif de serrage (214) étant prévu un premier élément de compensation (702a), destiné à une compensation des tolérances entre la première bride en céramique (300a) et la branche (400) et/ou entre la deuxième bride en céramique (300b) du deuxième composant en céramique (202, 208) et l'étrier (402) du dispositif de serrage (214) étant prévu un deuxième élément de compensation (702b) pour une compensation des tolérances entre la deuxième bride en céramique (300b) et l'étrier (402).

10. Agencement d'assemblage selon la revendication 9, la branche (400) comportant un évidement correspondant au premier élément de compensation (702a) et/ou l'étrier (402) comportant un évidement correspondant au deuxième élément de compensation (702b).

11. Agencement d'assemblage selon la revendication 9 ou 10, le premier élément de compensation (702a) étant collé sur la deuxième face (706a) de la première bride en céramique (300a) et/ou le deuxième élément de compensation (702b) étant collé sur la deuxième face (706b) de la deuxième bride en céramique (300b).

12. Agencement d'assemblage selon l'une quelconque des revendications 1 à 11, le dispositif de serrage (214) comportant un axe (408), pour la fixation en pivotement de la branche (400) sur l'étrier (402) et une vis de déplacement (406) pour le réglage de la force exercée (F1, F2).

13. Châssis de capteur (200), destiné à une installation lithographique (100), comportant un agencement d'assemblage (700) selon l'une quelconque des revendications 1 à 12.

14. Installation lithographique (100) dotée d'un châssis de capteur (200) selon la revendication 13 ou d'un agencement d'assemblage (700) selon l'une quelconque des revendications 1 à 12.

15. Procédé, destiné à l'assemblage par complémentarité de force de composants en céramique (202, 208) pour une installation lithographique, comprenant les étapes consistant à :
a) positionner un premier composant en céramique (202, 208) directement à côté d'un deuxième composant en céramique (202, 208),
b) presser le premier composant en céramique (202, 208) sur le deuxième composant en céramique (202, 208) au moyen d'un dispositif de serrage (214), le premier et le deuxième composants en céramique (202, 208) étant serrés l'un contre l'autre par complémentarité de force et par pivotement d'une branche (400) du dispositif de serrage (214), des forces étant réglées à l'aide desquelles la branche (400) et un étrier (402) du dispositif de serrage (214) pressent sur le premier et le deuxième composants en céramique (202, 208).
